# EUROPÄISCHE PATENTANMELDUNG

(11) **EP 2 244 087 A2**
(43) Veröffentlichungstag der Anmeldung: **27.10.2010**
(21) Anmeldenummer: 10003994.0
(22) Anmeldetag: 15.04.2010
(51) Int. Cl.: G01N 23/00, G01N 23/22

(54) **Referenzkörper für quantitative Röntgenfluoreszenzuntersuchungen an Substraten und Verfahren zu seiner Herstellung**

(30) Priorität: 23.04.2009 DE 102009019166
(71) Anmelder: Axo Dresden GmbH, 01809 Heidenau (DE)
(72) Erfinder: Dietsch, Reiner, 01217 Dresden (DE); Holz, Thomas, 01109 Dresden (DE); Weißbach, Danny, 01237 Dresden (DE)
(74) Vertreter: Pfenning, Meinig & Partner GbR

(57) **Zusammenfassung**

Die Erfindung betrifft ein Verfahren zur Herstellung eines Referenzkörpers für quantitative Röntgenfluoreszenzuntersuchungen an Substraten und einen mit dem Verfahren hergestellten Referenzkörper. Aufgabe der Erfindung ist es, ein Verfahren für die Herstellung von Referenzkörpern für Röntgenfluoreszenzuntersuchungen an Substraten, die mit Fremdelementen kontaminiert sein können, anzugeben, mit dem die Genauigkeit erhöht werden kann. Die Referenzkörper können mit mindestens einem Fremdelement kontaminiert sein, wobei auf einer Oberfläche des Referenzkörpers eine atomare Oberflächenbelegung mindestens eines chemischen Elementes mit einer Belegungsdichte kleiner als eine Atomlage vorhanden ist. Bei der Herstellung wird ein Target, das mit einer Beschichtung versehen ist, in der das/die chemische Element(e) mit einer bekannten Belegungsdichte und ein weiteres chemisches Element oder eine chemische Verbindung dieses chemischen Elements enthalten sind, mit einer gepulsten Strahlung innerhalb einer Vakuumkammer beaufschlagt, so dass eine Ablation der Beschichtung an der Oberfläche des Targets auf einer Fläche mit einer Größe A₀ₓ erfolgt und sich auf einer Teiloberfläche des in Bezug zur bestrahlten Oberfläche des Targets angeordneten Referenzkörpers auf einer Fläche A₀ₓ₊₁, die größer als die Fläche A₀ₓ ist, eine Belegung mit reduzierter Belegungsdichte des/der chemischen Element(e)s durch Abscheidung aus der Dampfphase ausgebildet wird.

## Beschreibung

Die Erfindung betrifft Referenzkörper für quantitative Röntgenfluoreszenzuntersuchungen an Substraten und ein Verfahren zur Herstellung solcher Referenzkörper.

Solche Untersuchungen werden beispielsweise durchgeführt, um die Ursachen von Ausfällen im Betrieb von Schaltkreisen zu finden. Häufig liegt eine Kontamination eines Werkstoffs vor. Eine Kontamination mit Partikeln kann aus einer Verletzung der Anforderungen an Reinräume während der Bearbeitung von Wafern resultieren. Eine Kontamination im Werkstoffvolumen kann beim Herstellungsprozess von Wafern erfolgt sein. Eine schichtartige Kontamination kann in Folge einer Wechselwirkung der Waferoberfläche mit der Umgebung aufgetreten sein. Je nach Ursache oder Art der aufgetretenen Kontamination kann nach deren Erkennung eine Ursachenvermeidung erfolgen.

Für viele Anwendungen ist es von Interesse, die Kontamination von Werkstoffen bzw. von Substraten mit chemischen Fremdelementen sehr genau zu bestimmen, da diese die Eigenschaften erheblich beeinflussen können. Dies ist auch bei sehr kleinen in solchen Werkstoffen enthaltenen Konzentrationen von Fremdelementen der Fall. So können Silicium-Wafer oder Wafer aus anderen Werkstoffen, wie z.B. Ge, Quarz, GaN oder Glaskohlenstoff entsprechend mit Fremdelementen kontaminiert sein, wodurch die elektrischen und halbleitenden Eigenschaften beeinflusst sind. Eine solche Kontamination kann auch bei Quarzglas, wie es z.B. in der Halbleiterfertigung einsetzbar ist, kritisch sein.

So ist aus WO 2007/068692 A1 ein Verfahren zur Bestimmung der Oberflächenbelegung eines Quarzglasbauteils bekannt, bei dem nasschemisch gearbeitet werden soll. Dies ist aber mit den hierbei bekannten Nachteilen, wie z.B. der gefährliche Umgang mit Säuren, verbunden.

Es ist gewünscht und angestrebt solche Untersuchungen an Substraten zerstörungsfrei und auch im Herstellungsprozess zumindest aber prozessnah durchzuführen. So wurde in DE 36 06 748 C1 eine Anordnung zur zerstörungsfreien Messung von Metallspuren in Oberflächen von Proben beschrieben. Solche Untersuchungen können an Silicium-Wafern durchgeführt werden, wobei eine Detektion mit Kontaminationen bis hin zu 10¹¹ at/cm² möglich sein soll.

Für eine Quantifizierung sind dabei Referenzkörper erforderlich, bei denen für eine Röntgenfluoreszenzanalyse geeignete Belegungen in dieser Größenordnung und auch darunter erforderlich sind. Bei so kleinen Belegungen mit Fremdelementen, die quantitativ detektierbar sein sollen, sollen die einzelnen Atome homogen über eine Fläche verteilt angeordnet sein. Sie können dabei aber keine geschlossene Schicht bilden, da eine so kleine Belegung kleiner als eine Atomlage auf einer Oberfläche ist.

Mit den bisher eingesetzten Verfahren kann eine "Inselbildung" von Atomen nicht vermieden werden. Dies bedeutet, dass die Anzahl der Atome über die Fläche nicht konstant ist und es einerseits Bereiche gibt, auf der eine größere Anzahl (Clusterbildung) und andere Bereiche mit kleinerer Anzahl von dort angeordneten Atomen vorhanden sind. Es ist aber gewünscht, dass bei einem Referenzkörper mit sehr kleiner Belegung im sub-Monolagenbereich eine konstante Belegungsdichte der jeweiligen Atome eines chemischen Elements über die Fläche, bis zu einem Maßstab < 100 nm, vorhanden ist.

Bei der TXRF/GIXRF können typische Messwertverläufe für verschiedene Typen von Kontaminationen (Oberfläche, Volumen, Partikel) von Fremdelementen in Abhängigkeit vom Einfallswinkel der Röntgenstrahlung ermittelt werden. Es ergeben sich jeweils typische Kurvenverläufe. Deutlich erkennbar sind die Unterschiede insbesondere bei einer Schicht- oder Partikelkontamination. Als Referenz für eine Partikelkontamination kann man Partikelreferenzproben nutzen. Für Schichtkontaminationen standen bis vor der Erfindung keine ausreichend geeigneten Referenzköper/-proben zur Verfügung.

Bei gleicher Konzentration bzw. enthaltenem Anteil von Fremdelementatomen können die Fluoreszenzmesswertsignale bis zu einem Faktor 4 differieren, je nachdem ob eine Volumen- oder Schichtkontamination oder Partikel die Ursache des jeweiligen Messwertsignals ist. In vielen Fällen liegen weisen die Kontaminationen auf der Oberfläche Schichtcharakter auf. In diesen Fällen sind Proben oder Referenzen mit Partikelcharakter ungeeignete Vergleichsstandards, da die Einfallswinkelabhängigkeit der Größe des Fluoreszenzmesssignals prinzipiell bei den unterschiedlichen Typen der Kontamination anders ist und mit bekannten Mitteln häufig nicht erfass- bzw. erkennbar ist.

Eine solche Fehlervermeidung kann aber mit den bisher eingesetzten Verfahren nicht gewährleistet werden. So treten Partikel bzw. "Inselbildungen" auf, wenn ein chemisches Element mit einer Flüssigkeit, in der es in sehr kleiner Konzentration enthalten ist, auf eine Oberfläche aufgebracht und die Flüssigkeit nachfolgend verdampft wird. Eine so ausgebildete Belegung ist auch nicht langzeitbeständig und ihre Eigenabsorption der einzelnen Fluoreszenzintensitäten an den Partikeln nicht reproduzierbar.

Bei einer Ausbildung einer Belegung mit an sich bekannten Vakuumbeschichtungsverfahren sind insbesondere technische Prozess- bzw. Technologieparameter einzustellen, um zu sehr kleinen Belegungsdichten zu kommen, wobei hohe Relativbewegungsgeschwindigkeiten, der Einsatz sehr kleiner Blendenöffnungen, größere oder veränderte Abstände zu einer Quelle mit einer Vergrößerung der zu beschichtenden Fläche (Nutzung des Projektionseffektes) Einflussparameter sind. Aber auch hier kann eine "Inselbildung" nicht vermieden werden. Problematisch ist auch die Reproduzierbarkeit mit definierter Belegungsdichte.

Bei sehr kleinen in solchen Substraten enthaltenen Anteilen an Fremdelement(en) ist eine quantitative Bestimmung mit ausreichender Genauigkeit bisher nicht möglich, da keine dies berücksichtigende Kalibrierung oder Referenzierung mit den bekannten technischen Mitteln erreichbar ist.

Es ist daher Aufgabe der Erfindung, Möglichkeiten für die Erhöhung der Genauigkeit bei quantitativen Röntgenfluoreszenzuntersuchungen an Proben, die mit Fremdelementen kontaminiert sein können, anzugeben.

Erfindungsgemäß wird diese Aufgabe mit Referenzkörpern, die die Merkmale des Anspruchs 1 aufweisen, gelöst. Sie können mit einem Verfahren gemäß Anspruch 10 hergestellt werden. Vorteilhafte Ausgestaltungen und Weiterbildungen der Erfindung sind mit Einsatz von in untergeordneten Ansprüchen bezeichneten Merkmalen erreichbar.

Bei einem erfindungsgemäßen Referenzkörper ist auf einer Oberfläche eine atomare Oberflächenbelegung mindestens eines chemischen Elementes mit einer Belegungsdichte, die kleiner als eine Atomlage ist, vorhanden. Die Oberfläche ist auf einer Teiloberfläche mit dem/den chemischen Element(en) mit einer Belegungsdichte kleiner 10¹⁶ at/cm² in homogener Verteilung versehen. Zusätzlich ist ein weiteres chemisches Element und/oder eine chemischen Verbindung dieses weiteren chemischen Elements, auf der Teiloberfläche vorhanden.

Die homogene Verteilung zeichnet sich dadurch aus, dass die Belegungsdichte auf einer Fläche von 1 mm * 1 mm genau so groß ist, wie auf einer Fläche mit einer Größe von 1 µm * 1 µm und sich alle Atome des chemischen Elements in einem Bereich der Beschichtung von wenigen nm von der Oberfläche des Referenzkörpers befinden.

Es können also mindestens ein erstes chemisches Element und mindestens ein zweites, als weiteres chemisches Element oder ein erstes chemisches Element und eine chemische Verbindung des Weiteren chemischen Elements in der Belegung vorhanden sein.

Das/die erste/ersten chemische(n) Element(e) auf der Teiloberfläche des Referenzkörpers kann/können identisch mit dem zu detektierenden Fremdelement der Probe sein. Ein solches erstes chemisches Element kann aber auch analoge Röntgenfluoreszenzeigenschaften, wie das jeweilige Fremdelement aufweisen und eine Ordnungszahl Z aufweisen, die beim eingesetzten Nachweisverfahren einen vergleichbaren quantitativen Nachweis ermöglicht.

Beispiele für geeignete Elemente als erste chemische Elemente sind Nickel, Scandium, Molybdän, oder Titan.

Als weiteres chemisches Element können solche mit kleinerer Ordnungszahl, wie z.B. Silicium, Kohlenstoff oder eine chemische Verbindung davon, wie z.B. Siliciumoxid, Siliciumnitrid oder Borcarbid in der Belegung auf dem Referenzkörper vorhanden sein. Es kann auch die chemische Verbindung des Werkstoffs von Proben für Vergleichsuntersuchungen bzw. eines Wafers selbst sein.

Die Belegungsdichte sollte kleiner als 10¹⁰ at/cm² skalierbar herstellbar sein. Dabei können Referenzkörper in skalierter Form mit Belegungen in den Größenordnungen kleiner 10¹⁴ at/cm², kleiner 10¹² at/cm², kleiner 10¹⁰ at/cm², kleiner 10⁸ at/cm² oder noch kleiner an Referenzkörpern zur Verfügung gestellt werden, die dann bei quantitativen Röntgenfluoreszenzuntersuchungen eingesetzt werden können, um Kontaminationen an oder in Proben, wie z.B. Wafern genau bestimmen zu können.

Das weitere chemische Element oder seine chemische Verbindung können die Beweglichkeit von Atomen des/der ersten chemischen Elemente(s) in der auf der Oberfläche ausgebildeten Belegung hemmen. Dadurch kann auch eine inhomogene Verteilung von Atomen ("Inselbildung") im Zeitverlauf vermieden werden.

Es kann ein Werkstoff für Referenzkörper eingesetzt werden, der röntgenoptisch neutrale Eigenschaften bei einer Röntgenfluoreszenzanalyse aufweist oder dem Werkstoff der zu untersuchenden Proben entspricht. So kann z.B. Silicium, Quarzglas, Germanium, Gallium-Nitrid oder Kohlenstoff als Werkstoff für Referenzkörper eingesetzt werden. Wird ein Referenzkörper aus dem Probenwerkstoff eingesetzt, sollte er keine Atome oder einen bekannten sehr kleinen Anteil an Atomen eines Fremdelementes enthalten.

Besitzt der Probenwerkstoff eine bekannte Volumenkontamination, dann weist der Referenzkörper sowohl Schicht- als auch Volumenkontamination auf und beide Signalverläufe der Fluoreszenzintensitäten als Funktion des Einfallswinkels der Röntgenstrahlung überlagern sich. Derartige Hybridreferenzkörper spiegeln die realen Verhältnisse besser wieder.

Eine erfindungsgemäß auszubildende Belegung kann dabei auf mindestens einem Bereich der Oberfläche des Referenzkörpers als Teiloberfläche vorhanden sein. Es können aber auch mehrere Teiloberflächen eines Referenzkörpers mit unterschiedlichen Belegungsdichten versehen sein, so dass eine Möglichkeit für eine Referenzierung/Kalibrierung in mehreren Stufen/Skalierungen mit einem einzigen Referenzkörper möglich ist. Solche Teiloberflächen an einem Referenzkörper sollten jedoch so angeordnet sein, dass eine gegenseitige Beeinflussung bei den röntgenoptischen Untersuchungen vermieden werden kann.

Bei einem Verfahren zur Herstellung der erfindungsgemäßen Referenzkörper wird ein erstes Target (x=1), das mit einer Beschichtung mit einer Schichtdicke (d < 1 µm) versehen ist, in der das/die chemische Element(e) mit einer bekannten Belegungsdichte, die größer als 10¹⁶ at/cm² sein kann, eingesetzt. Dabei kann die Belegungsdichte in der Beschichtung deutlich größer sein, so dass eine homogene Verteilung von Atomen dieses chemischen Elements über die Fläche und/oder das Beschichtungsvolumen gegeben ist. In der Beschichtung ist ein weiteres chemisches Element oder eine chemische Verbindung dieses chemischen Elements enthalten. Die Beschichtung wird mit einer gepulsten Strahlung innerhalb einer Vakuumkammer möglichst punktuell bestrahlt. Dabei erfolgt eine Ablation der Beschichtung und es bildet sich auf der Oberfläche des in Bezug zur bestrahlten Oberfläche des Targets angeordneten Referenzkörpers eine Belegung mit reduzierter Belegungsdichte des chemischen Elements durch Abscheidung aus der Dampfphase aus. Dabei wird ein relativ kleines Volumen der Beschichtung in die Gasphase überführt, das sich dann auf einer größeren Fläche A₀ₓ₌₂, als der Fläche der Beschichtung A₀ₓ₌₁ an der die Ablation durch die Strahlung erfolgt ist, absetzt und dort die Belegung ausbildet. So kann eine reproduzierbare Reduzierung (Verdünnung) der Atome des chemischen Elementes erreicht (reduzierte Elementkonzentration) und die Belegungsdichte in Bezug zu der ursprünglich in der Beschichtung vorhandenen Belegungsdichte dieser Atome reduziert werden. Die Anzahl der bestrahlten Flächen A₀ₓ beeinflusst daher die erreichte Belegungsdichte.

Im Gegensatz zu homogenen Volumentargets aus einem Werkstoff ohne Beschichtung hängt bei definiert beschichteten Targets die Anzahl der ablatierten Atome ausschließlich von der geometrischen Größe der Fläche von der ein Abtrag durch Ablation erfolgt ist, ab. Ist ein Abtrag an dieser Fläche erfolgt, ist die maximale Anzahl an ablatierten Atomen erreicht und eine Obergrenze gegeben. Impulslängen- und Impulsenergieveränderungen haben keinen proportionalen Einfluss auf die jeweilige Anzahl der Atome und die Belegungsdichte mehr. Auch zusätzliche Strahlungsimpulse führen bei der Herstellung von Referenzkörpern mit Hilfe von beschichteten Targets nicht zu einer weiteren Erhöhung der Belegungsdichte mit dem interessierenden chemischen Element. Es kann nur die Belegungsdichte des zweiten chemischen Elements erhöht werden, das aber neutral in Bezug auf Mess- und Blindwert des ersten chemischen Elements ist.

Auch das weitere chemische Element oder seine chemische Verbindung wird ablatiert und scheidet sich ebenfalls auf der Teiloberfläche des Referenzkörpers mit dem/den chemischen Element(en) ab, so dass auch hier die Belegung annähernd die gleiche Homogenität, wie die Beschichtung hat, und lediglich die Belegungsdichten reduziert sind.

Mit den Targets, die mit einer Beschichtung die mit dem/den chemischen Element(en), einem weiteren chemischen Element oder einer chemischen Verbindung dieses chemischen Elements versehen sind, kann bei der Ablation ausschließlich von der mit der Strahlung beaufschlagte Fläche, an der die Ablation auftritt, eine dementsprechende Anzahl von Atomen, die in die Gasphase überführt werden. Diese können sich dann auf einer größeren Teiloberfläche eines Referenzkörpers abscheiden. Wird weitere Strahlung auf diesen Bereich gerichtet, tritt eine solche Ablation nicht mehr auf und die Belegungsdichte des/der jeweiligen chemischen Elemente(s) in der Belegung auf der Teiloberfläche des Referenzkörpers bleibt konstant und wird dadurch nicht weiter erhöht.

Das aus der Beschichtung für die Ausbildung der Belegung nutzbare Volumen kann durch Einstellung der Prozessparameter, wie z.B. der Energie, mit der die Strahlung auf die Beschichtung gerichtet wird, die dabei unter Berücksichtigung der stoffspezifischen Absorption der Beschichtung eingetragene Leistung und den Abstand der beschichteten Substratfläche von der zu belegenden Referenzkörperfläche beeinflusst werden. Die Leistung kann dabei im einfachsten Fall durch die jeweilige Anzahl von Pulsen, bei möglichst konstanter Einzelpulslänge und Energie, eingestellt werden. So kann bereits eine bestimmte Belegungsdichte an der Teiloberfläche des Referenzkörpers eingehalten werden. Dies ist bei Einhaltung der gleichen Parameter auch bei einer nachfolgenden Herstellung weiterer Referenzkörper möglich, so dass eine hohe Reproduzierbarkeit gegeben ist.

Insbesondere wenn eine weitergehende Reduzierung der Belegungsdichte an einem Referenzkörper erreicht werden soll, kann das Verfahren mehrfach wiederholt werden und so eine stufenweise Verringerung der Belegungsdichten erreicht werden, in dem der an einer Teiloberfläche mit einer Belegung versehene Referenzkörper wieder als Target im Verfahren eingesetzt wird.

So kann nach der erstmaligen Durchführung des Verfahrens, ausgehend von einer Belegungsdichte einer Beschichtung eines Targets eine Oberfläche eines Referenzkörpers oder einem als Zwischenprodukt fungierenden Substrat, an dem eine Belegung mit bereits einmal reduzierter Belegungsdichte, wie vorab erläutert, erneut mit gepulster Strahlung beaufschlagt werden, um durch Ablation ein Volumen in die Gasphase zu überführen, das sich dann wieder auf einer größeren Fläche A₀ₓ₊ₙ eines weiteren Substrates oder Referenzkörpers abscheidet und dort eine Belegung mit einer weiter reduzierten Belegungsdichte der Atome des/der chemischen Elemente(s) auszubilden. Dies kann so oft wiederholt werden, bis die niedrigste gewünschte Belegungsdichte oder eine Nachweisgrenze erreicht worden ist.

Als Strahlung kann bevorzugt Laserstrahlung, besonders bevorzugt Strahlung eines gepulsten Lasers oder auch Elektronenstrahlung eingesetzt werden.

Mit einem erfindungsgemäßen Referenzkörper können Röntgenfluoreszenzuntersuchungen in an sich bekannter Form, beispielsweise mit einer aus DE 36 06 748 C1 bekannten Anordnung durchgeführt werden, indem Röntgenstrahlung abwechselnd auf eine Oberfläche eines zu prüfenden Substrats und einen erfindungsgemäßen Referenzkörpers mit bekannter Belegungsdichte gerichtet wird und so zumindest eine Aussage erhalten werden kann, ob die Kontamination mit einem Fremdelement im Substrat oder in einem zumindest oberflächennahen Bereich größer oder kleiner als die Anzahl von Atomen des chemischen Elements in der Belegung an der Oberfläche des Referenzkörpers ist.

An einem erfindungsgemäßen Referenzkörper kann zusätzlich ein Oberflächenbereich mit einer weiteren Referenzfläche, in der Partikel des chemischen Elements enthalten sind, versehen sein. Diese kann auf herkömmliche Weise, also durch eine Abdampfung einer Fremdatome enthaltenden Flüssigkeit, erhalten worden sein. Mit einem solchen Referenzkörper können dann weitere Vergleichsuntersuchungen durchgeführt werden.

Wie beim Hybridreferenzkörper mit Volumen- und Schichtkontamination beschrieben, kann durch Verdampfen einer Lösung mit bekannter Konzentration der Kontamination des ersten chemischen Elements ein Hybridreferenzkörper mit Schicht- und Partikelkontamination hergestellt werden, der wiederum reale Proben besser widerspiegelt. In Analogie kann auch ein Hybridreferenzkörper mit bekannter Volumen-, Partikel- und Schichtkantamination (Belegung) hergestellt werden.

Nachfolgend soll die Erfindung an Hand von Beispielen näher erläutert werden.

### Beispiel 1

Auf einem Silicium-Wafer als Target wurde ein Schichtsystem C/Ni/C durch ein Vakuumbeschichtungsverfahren ausgebildet. Dabei die Schichtdicke der Nickelschicht im Bereich 1 nm und die Schichtdicken der Kohlenstoffschichten im Bereich um 3 nm. Der Silicium-Wafer hatte eine Dicke > 1 µm. Nickel war bei diesem Beispiel das chemische Element mit dem der Referenzkörper mit der definierten sehr kleinen Belegungsdichte zur Verfügung gestellt werden sollte. Der Kohlenstoff bildete das zweite chemische Element, dessen Fluoreszenz den Mess- und Blindwert im Bereich der Fluoreszenzlinien des Nickel nicht beeinflusst.

Für die Ablation wurde ein gepulst betriebener Laserstrahl (PLD), der von einem Nd-YAG-Laser mit einer Wellenlänge λ von 1064 nm emittiert wurde, eingesetzt. Die Impulslänge war < 10 ns und die Impulsenergie < 1 J. Die Pulsfrequenz betrug 10 Hz. Die Wechselwirkungsfläche bei der Bestrahlung auf dem Target war ca. 0,8 mm² groß. Von dieser Fläche wurden die C/Ni/C-Beschichtung also auch die3 bis 4 Monolagen von Nickelatmomen, die der 1 nm Schichtdicke entsprechen ablatiert und damit eine Fläche, die > als 2 cm² war, auf der Oberfläche eines Referenzkörpers beschichtet. Die für die TXRF- Untersuchungen neutralen Silicium- und Kohlenstoffatome setzten sich mit größerer Anzahl ebenfalls auf dem Referenzkörper ab und verhindern eine Inselbildung von Nickelatomen durch Hemmung der Diffusion. In der Beschichtung auf dem Referenzkörper konnte die Belegungsdichte gegenüber der in der Beschichtung des Substrates um 2-Größenordnungen, nämlich von 10¹⁷ at/cm² auf 10¹⁵ at/cm² reduziert werden.

Durch Wiederholung dieser Vorgehensweise, also einer analogen Bestrahlung der Beschichtung auf dem Referenzkörper mit Ablation einer entsprechend kleinen Wechselwirkungsfläche und dann einer weiteren Beschichtung auf einer größeren Fläche kann die Belegungsdichte entsprechend weiter reduziert werden.

## Patentansprüche

1. Referenzkörper für quantitave Röntgenfluoreszenzuntersuchungen an Proben, die mit mindestens einem Fremdelement kontaminiert sein können, bei dem auf einer Oberfläche eine atomare Oberflächenbelegung mindestens eines chemischen Elementes mit einer Belegungsdichte kleiner als eine Atomlage vorhanden ist,
**dadurch gekennzeichnet, dass**
mindestens ein Teilbereich der Oberfläche des Referenzköpers mit dem mindestens einen chemischen Element mit einer Belegungsdichte kleiner 10¹⁶ at/cm² in homogener Verteilung und einem weiteren chemischen Element oder einer chemischen Verbindung des weiteren chemischen Elements belegt ist.

2. Referenzkörper nach Anspruch 1, **dadurch gekennzeichnet, dass** das chemische Element, das zu detektierende Fremdelement ist oder analoge Röntgenfluoreszenzeigenschaften aufweist.

3. Referenzkörper nach Anspruch 1, **dadurch gekennzeichnet, dass** das Element ausgewählt ist, aus Nickel, Eisen, Kupfer, Titan. Molybdän und Scandium.

4. Referenzkörper nach einem der vorhergehenden Ansprüche, **dadurch gekennzeichnet, dass** das weitere chemische Element ausgewählt ist aus Silicium, Kohlenstoff, Gallium und Germanium.

5. Referenzkörper nach einem der vorhergehenden Ansprüche, **dadurch gekennzeichnet, dass** die Belegungsdichte des/der chemischen Element(e)s kleiner 10¹° at/cm² ist/sind.

6. Referenzkörper nach einem der vorhergehenden Ansprüche, **dadurch gekennzeichnet, dass** der Referenzkörper aus Silicium, Quarzglas, Germanium, Gallium-Nitrid oder dem Probenwerkstoff gebildet ist.

7. Referenzkörper nach einem der vorhergehenden Ansprüche, **dadurch gekennzeichnet, dass** die Probe und/oder der Referenzkörper ein Wafer ist/sind.

8. Referenzkörper nach einem der vorhergehenden Ansprüche, **dadurch gekennzeichnet, dass** am Referenzkörper mindestens zwei separate Teiloberflächen, die mit dem/den chemischen Element(en) mit jeweils voneinander abweichender Belegungsdichte belegt sind, vorhanden sind.

9. Referenzkörper nach einem der vorhergehenden Ansprüche, **dadurch gekennzeichnet, dass** eine zusätzliche Referenzfläche, auf der eine Partikelkontamination des chemischen Elements vorliegt, vorhanden ist.

10. Verfahren zur Herstellung eines Referenzkörpers nach einem der vorhergehenden Ansprüche, **dadurch gekennzeichnet, dass** ein Target, das mit einer Beschichtung versehen ist, in der das/die chemische Element(e) mit einer bekannten Belegungsdichte und ein weiteres chemisches Element oder eine chemische Verbindung dieses chemischen Elements enthalten sind, mit einer gepulsten Strahlung innerhalb einer Vakuumkammer beaufschlagt wird, so dass eine Ablation der Beschichtung an der Oberfläche des Targets auf einer Fläche mit einer Größe A₀ₓ erfolgt und sich auf einer Teiloberfläche des in Bezug zur bestrahlten Oberfläche des Targets angeordneten Referenzkörpers auf einer Fläche A₀ₓ₊₁, die größer als die Fläche A₀ₓ ist, eine Belegung mit reduzierter Belegungsdichte des/der chemischen Element(e)s durch Abscheidung aus der Dampfphase ausgebildet wird.

11. Verfahren nach Anspruch 10, **dadurch gekennzeichnet, dass** die Belegungsdichte auf der Teiloberfläche des Referenzkörpers durch die Anzahl der bestrahlten Flächen A₀ₓ mit der die Beschichtung beaufschlagt wird und/oder dem Abstand der Beschichtung des Targets und der jeweiligen Oberfläche des Referenzkörpers eingestellt wird.

12. Verfahren nach Anspruch 10 oder 11, **dadurch gekennzeichnet, dass** ein mit einer Belegung versehener Referenzkörper als Target benutzt und mit gepulster Strahlung beaufschlagt wird, um durch Ablation und Abscheidung aus der Dampfphase auf einem weiteren Referenzkörper eine Belegung auf einer Teiloberfläche mit einer Fläche A₀ₓ₊ₙ mit weiter reduzierter Belegungsdichte des/der chemischen Element(e)s auszubilden.

13. Verfahren nach einem der Ansprüche 10 bis 12, **dadurch gekennzeichnet, dass** von einer Laserlichtquelle emittierte Strahlung oder ein Elektronenstrahl für die Ablation eingesetzt wird.
